**Europäisches Patentamt**

**European Patent Office**

**Office européen des brevets**

(19)

(11) Numéro de publication : **0 547 968 A1**

## (12) DEMANDE DE BREVET EUROPEEN

(21) Numéro de dépôt : **92403427.5**

(22) Date de dépôt : **16.12.92**

(51) Int. Cl.$^5$ : **G01R 27/26,** G01N 22/00, H01P 7/10

(30) Priorité : **19.12.91 FR 911580**

(43) Date de publication de la demande : **23.06.93 Bulletin 93/25**

(84) Etats contractants désignés : **BE CH GB LI**

(71) Demandeur : **COMMISSARIAT A L'ENERGIE ATOMIQUE 31-33, rue de la Fédération F-75015 Paris (FR)**

(72) Inventeur : **Philippe, Naud 7 Résidence Camponac F-33600 Pessac (FR)** Inventeur : **Guillon, Pierre 80, Avenue Baudin F-87000 Limoges (FR)**

(74) Mandataire : **Mongrédien, André et al c/o BREVATOME 25, rue de Ponthieu F-75008 Paris (FR)**

(54) **Système de mesure de paramètres diélectriques et magnétiques de matériaux.**

(57) Ce système comprend un résonateur diélectrique parallélépipèdique (2) dont deux faces opposées et la face joignant celles-ci sont conductrices. Le système comprend aussi des moyens (16, 18) pour exciter le résonateur et détecter un signal issu du résonateur excité, des moyens (20) pour commander cette excitation et mesurer la fréquence de résonance et le coefficient de qualité du résonateur grâce à ce signal , un boîtier conducteur (22) dont une face est ouverte et placée en regard du matériau étudié (12) et dans lequel sont placés le résonateur et les moyens d'excitation et de détection, ce qui permet de déterminer deux des paramètres du matériau connaissant les autres. Application à la caractérisation des matériaux pour composants hyperfréquences.

FIG. 2

EP 0 547 968 A1

La présente invention concerne un système de mesure de paramètres diélectriques et magnétiques de matériaux.

L'invention permet de faire ces mesures par simple contact, sans destruction des matériaux sur lesquels les mesures sont faites.

Ces matériaux peuvent être isotropes ou anisotropes.

L'invention permet de faire des mesures sur un matériau massif ou sur un matériau déposé sur un support qui est par exemple métallique.

Les paramètres diélectriques que la présente invention permet de mesurer sont la partie réelle E1 et la partie imaginaire E2 de la permittivité complexe E d'un matériau, qui est telle que :

$$E = E1 - jE2$$

où $j^2 = -1$.

Les paramètres magnétiques que la présente invention permet de mesurer sont la partie réelle M1 et la partie imaginaire M2 de la perméabilité magnétique complexe M du matériau qui est telle que :

$$M = M1 - jM2$$

Plus précisément, la présente invention permet de mesurer les paramètres E1 et E2, connaissant les paramètres M1 et M2 grâce à des moyens de mesure annexes, ou de mesurer ces paramètres M1 et M2, connaissant les paramètres E1 et E2 grâce à des moyens de mesure annexes.

Plus généralement, la présente invention permet de mesurer deux des paramètres E1, E2, M1 et M2 connaissant les deux autres grâce à des moyens de mesure annexes.

L'invention permet également de déterminer le coefficient de réflexion à la surface du matériau, que celui-ci soit ou non métallisé à l'arrière, ce coefficient de réflexion étant fonction des paramètres E et M ainsi que de l'épaisseur du matériau testé.

On connaît déjà par le document

(1) EP-A-0418117, "Dispositif de caractérisation diélectrique d'échantillons de matériau de surface plane ou non plane et application au contrôle non destructif de l'homogénéité diélectrique desdits échantillons",

un dispositif permettant de mesurer des paramètres diélectriques d'un matériau.

Ce dispositif connu, constitué d'une ligne coaxiale débouchant sur le matériau que l'on veut caractériser, est apte à fonctionner à partir de 100 MHz avec des dimensions raisonnables.

Cependant, il ne permet pas d'analyser les caractéristiques magnétiques du matériau, ce qui limite considérablement le champ d'application de ce dispositif.

De plus, le procédé de mesure décrit dans ce document (1), qui s'appuie sur une modélisation du type "capacité équivalente" en bout de ligne, n'utilise qu'une information prélevée dans la couche superficielle du matériau et ne permet pas de contrôler ce

dernier dans toute son épaisseur.

On connaît aussi par le document

(2) Etude du guide d'ondes ouvert - Application aux mesures non destructives des matériaux, Thèse n° 549 (1984), Ecole Polytechnique Fédérale de Lausanne,

un autre dispositif de mesure utilisant un guide d'onde circulaire qui est appliqué sur le matériau à caractériser.

Dans ce cas, les dimensions de ce dispositif de mesure sont directement liées à la fréquence de travail et deviennent très grandes en-dessous de 5GHz.

Pour effectuer des mesures entre 100 MHz et 1GHz, cet autre dispositif connu n'est pas utilisable.

La présente invention a pour but de remédier aux inconvénients précédents en proposant un système qui permet de mesurer tant des paramètres diélectriques que des paramètres magnétiques d'un matériau et qui est apte à fonctionner à une fréquence se situant dans une gamme allant de 100 MHz à quelques GHz tout en gardant des dimensions raisonnables.

De façon précise, la présente invention a pour objet un système de mesure de paramètres diélectriques et magnétiques de matériaux, caractérisé en ce qu'il comprend :

- un résonateur diélectrique parallélépipèdique dont deux faces opposées ainsi que la face joignant ces deux faces opposées sont rendues électriquement conductrices,

- des moyens d'excitation et de détection, prévus pour exciter le résonateur par un signal de fréquence variable autour de la fréquence de résonance de ce résonateur et pour détecter le signal issu du résonateur ainsi excité, dont la fréquence de résonance et le coefficient de qualité sont perturbés lorsque ce résonateur est appliqué sur un matériau dont les paramètres sont à mesurer,

- des moyens de commande et de mesure, prévus pour commander l'excitation du résonateur et pour mesurer la fréquence de résonance et le coefficient de qualité grâce au signal détecté, et

- un boîtier électriquement conducteur dont une face est ouverte et destinée à être placée en regard du matériau, le résonateur et les moyens d'excitation et de détection étant placés dans ce boîtier pour faire la mesure,

le système permettant ainsi de déterminer deux des paramètres diélectriques et magnétiques du matériau connaissant les deux autres de ces paramètres.

Ainsi, lorsque le résonateur est appliqué sur le matériau dont les paramètres sont à mesurer, en excitant le résonateur par un signal de fréquence variable autour de la fréquence de résonance de ce résonateur et en détectant le signal issu de ce dernier, il est possible de déterminer les paramètres en mesurant la fréquence de résonance et le coefficient de qualité du résonateur, qui sont perturbés par le matériau.

Même aux fréquences les plus basses de la gamme allant de 100 MHz à quelques GHz, il est possible de réaliser un système conforme à l'invention dont la taille est raisonnable.

On peut ainsi tester efficacement l'homogénéité diélectrique ou magnétique du matériau et localiser précisément d'éventuels défauts de ce matériau.

Pour la précision des mesures, il est préférable que la surface du matériau testé soit plane ou ait du moins un fort rayon de courbure.

Selon un mode de réalisation particulier de l'invention, les deux faces opposées du résonateur ainsi que la face joignant ces deux faces opposées sont métallisées.

Ce résonateur diélectrique peut comprendre un bloc parallélipédique en céramique.

Contrairement au dispositif décrit dans le document (1), le système objet de l'invention permet de contrôler un matériau dans toute l'épaisseur de celui-ci.

De plus, le système objet de l'invention permet de caractériser des matériaux à très faibles pertes électriques et/ou magnétiques, ce qui n'est pas le cas des techniques décrites dans les documents (1) et (2).

Selon un mode de réalisation particulier du système objet de l'invention, les moyens d'excitation et de détection comprennent une première sonde magnétique prévue pour l'excitation du résonateur et une deuxième sonde magnétique prévue pour la détection du signal issu de résonateur, ces sondes étant disposées de part et d'autre du résonateur dans le boîtier électriquement conducteur.

Le système objet de l'invention peut comprendre en outre des moyens électroniques de traitement de signaux de mesure fournis par les moyens de commande et de mesure, ces moyens de traitement étant prévus pour fournir les paramètres recherchés.

Ce système peut comprendre en outre des moyens de positionnement du résonateur, des première et deuxième sondes magnétiques et du boîtier par rapport au matériau, de façon à pouvoir déterminer les paramètres en plusieurs points du matériau.

Enfin, les moyens électroniques de traitement peuvent être en outre prévus pour commander les moyens de positionnement.

La présente invention sera mieux comprise à la lecture de la description d'exemples de réalisation donnés ci-après à titre purement indicatif et nullement limitatif, en référence aux dessins annexés sur lesquels :

- la figure 1 est une vue schématique d'un mode de réalisation particulier du résonateur utilisé dans l'invention et
- la figure 2 est une vue schématique d'un mode de réalisation particulier du système objet de l'invention, comprenant le résonateur représenté sur la figure 1.

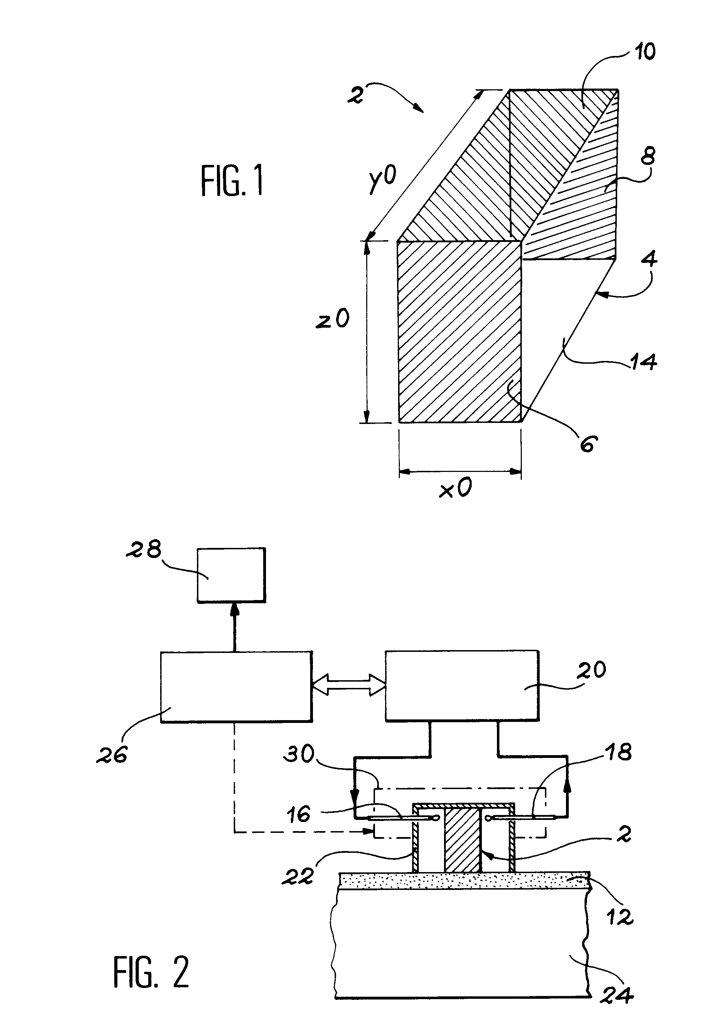

Le résonateur 2 qui est schématiquement représenté sur la figure 1, est un résonateur diélectrique comportant un bloc parallélipédique 4 fait d'un matériau diélectrique, par exemple la céramique.

Deux faces opposées 6 et 8 de ce bloc 4 ainsi que la face 10 qui joint ces deux faces opposées 6 et 8 sont rendues électriquement conductrices et, pour ce faire, sont par exemple métallisées.

Cette métallisation est par exemple obtenue en déposant sur ces faces 6, 8 et 10 une couche d'aluminium, de cuivre ou d'or ou encore une couche de laque d'argent, l'épaisseur de ces couches étant choisie de façon à obtenir une conductivité électrique équivalente à celle du métal considéré (aluminium, cuivre, or ou argent).

Le système conforme à l'invention, qui est schématiquement représenté sur la figure 2, est destiné à mesurer des paramètres diélectriques et magnétiques d'un matériau 12, par exemple un matériau utilisé dans des composants hyperfréquences.

Ce système comprend le résonateur 2 représenté sur la figure 1 et ce résonateur repose sur une face du matériau 12 qui est sensiblement plane ou à fort rayon de courbure.

Dans l'exemple représenté, la face 14 du bloc 4, qui est opposée à la face 10 et qui n'est pas métallisée, repose sur cette face du matériau 12.

Le système schématiquement représenté sur la figure 2 comprend également deux sondes magnétiques 16 et 18 qui sont disposées de part et d'autre du dispositif 2 et qui sont respectivement placées en regard des deux autres faces non métallisées du bloc 4, comme on le voit sur la figure 2.

La sonde magnétique 16 est destinée à l'excitation du résonateur 2 tandis que la sonde magnétique 18 est destinée à capter un signal résultant de cette excitation, comme on le comprendra mieux par la suite.

Lorsque le résonateur 2 est excité, des ondes électromagnétiques se propagent dans ce résonateur perpendiculairement à la face métallisée 10 et l'on note zO la dimension du bloc 4 qui est perpendiculaire à cette face 10 et qui peut être considérée comme la hauteur du bloc 4.

Les deux autres dimensions de ce bloc 4 sont notées xO et yO comme on le voit sur la figure 1.

On note respectivement fO et QO la fréquence de résonance et le coefficient de qualité du résonateur diélectrique 2 lorsque ce dernier est libre, c'est-à-dire n'est pas posé sur un matériau à caractériser.

Dans le cas contraire, c'est-à-dire lorsque ce résonateur est appliqué sur un tel matériau, la fréquence de résonance et le coefficient de qualité du résonateur sont perturbés par la présence du matériau et sont alors respectivement notés f1 et Q1.

A la fréquence fO, le résonateur de hauteur zO engendre un mode de propagation des ondes électromagnétiques de type transverse électromagnétique (TEM) qui, au premier ordre est tel que :

$$zO = c/(4.fO.Er^{1/2})$$

où : c représente la célérité de la lumière dans le vide (en m/s)

Er représente la permittivité relative du résonateur

la fréquence de résonance fO est exprimée en Hz.

Ainsi, pour Er=36 (valeur qui est courante dans les résonateurs diélectriques), on obtient, autour de 2 GHz, une hauteur zO égale à 6,25 mm.

Dans ce cas, on donne respectivement à xO et yO les valeurs 8,5 mm et 6 mm.

Ces valeurs sont suffisamment faibles pour obtenir une bonne précision de localisation lors des relevés faits à la surface du matériau 12.

Selon l'invention, l'ensemble constitué par le résonateur 2 et le matériau à caractériser 12 est modélisé avec un logiciel utilisant la méthode des éléments finis.

Les valeurs xO et yO qui sont données ci-dessus sont des valeurs optimisées avec ce modèle et avec le souci de réduire la taille du dispositif 2 tout en conservant un facteur de qualité suffisant pour faire la mesure.

Avec Er=36 et une fréquence de résonance fO de 400 MHz, la dimension zO change et passe à 51 mm, les autres dimensions xO et yO du résonatur gardant les mêmes valeurs que précédemment.

On remarquera que la métallisation choisie pour le résonateur 2 provoque une orientation rectiligne bien identifiée du champ électromagnétique (particularité du mode TEM).

De ce fait, le dispositif de la figure 1 permet d'obtenir des informations exploitables non seulement dans le cas de matériaux isotropes mais encore dans le cas de matériaux anisotropes dont les caractéristiques radioélectriques dépendent de l'orientation du champ électromagnétique.

Comme on l'a vu plus haut, le système de la figure 2 utilise, pour faire les mesures, une méthode de perturbation du facteur de qualité et de la fréquence de résonance du résonateur 2 qui est excité au moyen de la sonde magnétique 16, la sonde magnétique 18 détectant le signal issu du résonateur ainsi excité.

Le système de la figure 2 comprend également un appareil de mesure 20 prévu pour envoyer dans la sonde 16 (boucle magnétique) un signal hyper-fréquence d'excitation, à une fréquence variable autour de la fréquence de résonance fO.

De plus, cet appareil de mesure 20 est prévu pour détecter, par l'intermédiaire de la boucle magnétique constituée par l'autre sonde 18, le signal utile issu du résonateur (le système de mesure fonctionnant ainsi en transmission) et pour déterminer les quantités f1 et Q1.

Comme on l'a vu plus haut, l'information utilisée

pour remonter aux caractéristiques diélectriques et magnétiques du matériau 12 est la perturbation du coefficient de qualité et de la fréquence de résonance du résonateur 2, perturbation qui est causée par le matériau sur lequel est appliqué ce résonateur.

Dans l'exemple représenté sur la figure 2, l'appareil de mesure 20 est un analyseur de réseaux par exemple du genre de celui qui est commercialisé par la société Hewlett Packard sous la référence HP8510.

D'autres systèmes d'excitation pourraient être utilisés afin d'optimiser le couplage entre les sondes et l'appareil de mesure.

Par exemple, une ligne micro-ruban permettrait d'obtenir un bon couplage avec une meilleure tenue mécanique que les boucles magnétiques représentées sur la figure 2.

Dans l'invention, le procédé de détermination des caractéristiques radio-électriques consiste à effectuer le calcul d'un abaque donnant la valeur du coefficient de qualité Q1 et celle de la fréquence de résonance f1 pour différentes valeurs des caractéristiques E1, E2, M1 et M2 du matériau autour du point mesuré.

La précision recherchée sur la détermination des caractéristiques fixe le pas à respecter pour le calcul de l'abaque.

Une fois cet abaque tracé, il suffit de reporter le couple (f1, Q1) mesuré grâce à l'appareil de mesure 20 et de lire les valeurs des deux paramètres ( réels) recherchés, connaissant les deux autres.

Bien entendu, la détermination peut être répétée sans calcul pour d'autres matériaux dont les caractéristiques se situent dans le domaine couvert par l'abaque.

On précise que la méthode utilisée (méthode des éléments finis) impose de disposer d'un volume fini pour résoudre correctement le problème

C'est pourquoi le système représenté sur la figure 2 comprend en outre un boîtier métallique 22 par exemple en cuivre, dans lequel est enfermé le résonateur 2, comme on le voit sur la figure 2.

De plus, ce boîtier 22 comporte une seule face ouverte et repose sur le matériau 12 par cette face ouverte.

On peut ainsi utiliser des conditions du type "conducteur parfait" sur cinq des six faces du volume considéré, la sixième face étant constituée par le matériau étudié.

On notera à ce sujet que la méthode utilisée dans l'invention permet de tester aussi bien des matériaux déposés sur un support 24, par exemple métallique, de caractéristiques connues, que des matériaux massifs (non déposés sur un support).

Comme on le voit sur la figure 2, les sondes 16 et 18 traversent le boîtier 22 qui est pourvu de trous à cet effet.

Le système représenté sur la figure 2 comprend également des moyens électroniques de traitement 26, par exemple une station de travail du genre de celle qui est commercialisée par la société Hewlett Packard sous la référence HP9000, sur laquelle fonctionne le logiciel de calcul développé pour la mise en oeuvre de la méthode indiquée plus haut.

Cette station de travail peut être équipée d'un logiciel de pilotage d'instrumentations développé pour les mesures considérées, afin d'automatiser ces mesures.

Dans ce cas, la station de travail 26 assure les fonctions suivantes :
- étalonnage de l'appareil de mesure,
- mise en configuration de cet appareil,
- aquisition et stockage du couple ou des couples de paramètre (f1, Q1),
- saisie d'un critère de précision sur la détermination des caractéristiques du matériau,
- saisie des bornes pour le tracé de l'abaque,
- calcul et tracé de l'abaque sur une table traçante 28.

Dans le but d'effectuer la cartographie des caractéristiques radioélectriques d'un échantillon, le système représenté sur la figure 2 peut comprendre en outre des moyens de positionnement 30, ou positionneur, de l'ensemble constitué par le dispositif 2, les sondes 16 et 18 et le boîtier 22 par rapport au matériau 12.

Suivant la forme de ce dernier, on utilise un positionneur suivant un, deux ou trois axes.

Dans ce cas, pour automatiser encore plus les mesures, la station de travail 26 peut être prévue pour assurer également les fonctions suivantes :
- pilotage du positionneur,
- synchronisation et déclenchement des mesures,
- interpolation logicielle entre les valeurs de l'abaque calculées et les valeurs mesurées, ce qui rend d'ailleurs le procédé de mesure entièrement automatique,
- stockage et présentation des résultats.

La présente invention trouve des applications dans divers domaines.

Elle s'applique entre autres à la caractérisation des matériaux utilisés pour les composants hyperfréquences (circulateurs, isolateurs, résonateurs, substrats) qui peuvent être efficacement contrôlés par un système conforme à l'invention pendant leur fabrication.

L'invention s'applique également à la détermination de la teneur en eau de matériaux, cette teneur en eau étant déterminable par des mesures de permittivité.

Ainsi, l'invention trouve des applications en biologie.

La présente invention s'applique également à la détection de certains défauts d'homogénéité, en révélant la présence de corps étrangers ou de modifications locales des propriétés d'un matériau testé.

L'utilisation d'une table traçante X-Y permet de localiser des défauts par cartographie de la surface précitée.

## Revendications

1. Système de mesure de paramètres diélectriques et magnétiques de matériaux, caractérisé en ce qu'il comprend :
   - un résonateur diélectrique parallélépipèdique (2) dont deux faces opposées (6, 8) ainsi que la face (10) joignant ces deux faces opposées sont rendues électriquement conductrices,
   - des moyens (16, 18) d'excitation et de détection, prévus pour exciter le résonateur (2) par un signal de fréquence variable autour de la fréquence de résonance de ce résonateur (2) et pour détecter le signal issu du résonateur ainsi excité, dont la fréquence de résonance et le coefficient de qualité sont perturbés lorsque ce résonateur est appliqué sur un matériau (12) dont les paramètres sont à mesurer,
   - des moyens (20) de commande et de mesure, prévus pour commander l'excitation du résonateur (2) et pour mesurer la fréquence de résonance et le coefficient de qualité grâce au signal détecté, et
   - un boîtier (22) electriquement conducteur dont une face est ouverte et destinée à être placée en regard du matériau (12), le résonateur et les moyens (16, 18) d'excitation et de détection étant placés dans ce boîtier (22) pour faire la mesure,

   le système permettant ainsi de déterminer deux des paramètres diélectriques et magnétiques du matériau (12) connaissant les deux autres de ces paramètres.

2. Système selon la revendication 1, caractérisé en ce que les deux faces opposées (6, 8) ainsi que la face (10) joignant ces deux faces opposées sont métallisées.

3. Système selon l'une quelconque des revendications 1 et 2, caractérisé en ce que le résonateur diélectrique (2) comprend un bloc parallélépipédique (4) en céramique.

4. Système selon l'une quelconque des revendications 1 à 3, caractérisé en ce que les moyens d'excitation et de détection comprennent une première sonde magnétique (16) prévue pour l'excitation du résonateur (2) et une deuxième sonde magnétique (18) prévue pour la détection du signal issu de ce résonateur (2), ces sondes étant disposées de part et d'autre du résonateur dans le boîtier électriquement conducteur (22).

5. Système selon l'une quelconque des revendications 1 à 4, caractérisé en ce qu'il comprend en outre des moyens électroniques (26) de traitement de signaux de mesure fournis par les moyens (20) de commande et de mesure, ces moyens de traitement étant prévus pour fournir les paramètres recherchés.

6. Système selon l'une quelconque des revendications 1 à 5, caractérisé en ce qu'il comprend en outre des moyens (30) de positionnement du résonateur, des première (16) et deuxième (18) sondes magnétiques et du boîtier (22) par rapport au matériau (12), de façon à pouvoir déterminer les paramètres en plusieurs points du matériau.

7. Système selon les revendications 5 et 6, caractérisé en ce que les moyens électroniques de traitement (26) sont en outre prévus pour commander les moyens de positionnement (30).

FIG. 1

FIG. 2

Office européen
des brevets

**RAPPORT DE RECHERCHE EUROPEENNE**

Numero de la demande

EP 92 40 3427

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | EP-A-0 108 003 (THOMSON-CSF) * Page 3, lignes 10-14; page 4, lignes 5-8; page 6, ligne 15 - page 7, ligne 12; figures 4-6 * --- | 1,2,4 | G 01 R 27/26 G 01 N 22/00 H 01 P 7/10 |
| A | 1988 IEEE MTT INTERNATIONAL MICROWAVE SYMPOSIUM DIGEST, New York, 25-27 mai 1988, vol. 2, pages 743-746, IEEE New York, US; B.B. SZENDRENYI et al.: "An alternative broadband method for automatic measurement of the complex permeability and permittivity of materials at microwave frequencies" * Le document en entier * --- | 1,5 | |
| A | EP-A-0 288 135 (UNITED KINGDOM ATOMIC ENERGY AUTHORITY) * Abrégé; figure 2 * --- | 1 | |
| A | US-A-5 002 913 (YAMADA et al.) * Abrégé * --- | 3 | DOMAINES TECHNIQUES RECHERCHES (Int. Cl.5) |
| A | CPEM'86 DIGEST, 1986 CONFERENCE ON PRECISION ELECTROMAGNETIC MEASUREMENTS, Gaithersburg, MD, 23-27 juin 1986, pages 154-155, IEEE, New York, US; J. KRUPKA et al.: "Application of TE01delta mode dielectric resonator for the complex permittivity measurements of semiconductors" * Le document en entier * --- -/- | 1,5 | G 01 R G 01 N H 01 P |

Le présent rapport a été établi pour toutes les revendications

| Lieu de la recherche | Date d'achèvement de la recherche | Examinateur |
|---|---|---|
| LA HAYE | 25-03-1993 | SINAPIUS G H |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

............................................................
& : membre de la même famille, document correspondant

EPO FORM 1503 03.82 (P0402)

**Office européen**

**des brevets**

# RAPPORT DE RECHERCHE EUROPEENNE

Numero de la demande

EP   92 40 3427

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | GB-A-2 234 826  (MURATA)<br>* Abrégé; page 2, ligne 5 - page 3, ligne 15; page 17, ligne 6 - page 19, ligne 11; figures 1,2,16 *<br>----- | 1,4,5 | |
| | | | **DOMAINES TECHNIQUES RECHERCHES (Int. Cl.5)** |

**Le présent rapport a été établi pour toutes les revendications**

| Lieu de la recherche | Date d'achèvement de la recherche | Examinateur |
|---|---|---|
| LA HAYE | 25-03-1993 | SINAPIUS G H |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
........................................................................
& : membre de la même famille, document correspondant

EPO FORM 1503 03.82 (P0402)